(19) **Europäisches Patentamt / European Patent Office / Office européen des brevets**

(11) **EP 3 722 907 B1**

(12) # EUROPEAN PATENT SPECIFICATION

(45) Date of publication and mention
of the grant of the patent:
**22.02.2023 Bulletin 2023/08**

(21) Application number: **19168036.2**

(22) Date of filing: **09.04.2019**

(51) International Patent Classification (IPC):
***G05D 1/02*** *(2006.01)*

(52) Cooperative Patent Classification (CPC):
**G06F 30/27; G06F 30/15;** G06F 11/3668

(54) **LEARNING A SCENARIO-BASED DISTRIBUTION OF HUMAN DRIVING BEHAVIOR FOR REALISTIC SIMULATION MODEL AND DERIVING AN ERROR MODEL OF STATIONARY AND MOBILE SENSORS**

LERNEN EINER SZENARIOBASIERTEN VERTEILUNG VON MENSCHLICHEM FAHRVERHALTEN FÜR EIN MODELL ZUR REALISTISCHEN SIMULATION UND ZUR ABLEITUNG EINES FEHLERMODELLS VON STATIONÄREN UND MOBILEN SENSOREN

APPRENTISSAGE D'UNE DISTRIBUTION BASÉE SUR LE SCÉNARIO D'UN COMPORTEMENT DE CONDUITE HUMAIN RÉALISTE POUR MODÈLE DE SIMULATION RÉALISTE ET DÉRIVATION D'UN MODÈLE D'ERREUR DE CAPTEURS STATIONNAIRES ET MOBILES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**14.10.2020 Bulletin 2020/42**

(73) Proprietor: **Bayerische Motoren Werke Aktiengesellschaft 80809 München (DE)**

(72) Inventors:
 • **Groh, Korbinian**
  **85386 Dietersheim (DE)**
 • **Notz, Dominik**
  **Belmont, CA California 94002 (US)**
 • **Kuehbeck, Thomas**
  **Mountain View, CA California 94043 (US)**
 • **Inonu, Mehmet**
  **Redwood City, CA California 94062 (US)**

(56) References cited:
 **CN-A- 108 805 348     US-A1- 2019 035 275
 US-A1- 2019 072 966**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## Field

Embodiments of the present disclosure relate to systems, apparatuses and methods for determining a computer model of realistic driving behavior using a machine learning based driving behavior simulator.

## Background

Computer models of driving behavior can be used in fields of automotive development. In the field of autonomous driving, for example, computer models can play an important role. For example, autonomously driving vehicles can be trained and tested by using computer models in order to eliminate errors before testing the autonomous driving systems under real conditions in traffic. For testing autonomous driving systems, it may be advantageous to develop computer models, which can reproduce a realistic driving behavior of vehicles.

Conventional computer models are based on non-empirical parameters which may not be appropriate to reproduce the realistic driving behavior of vehicles. Especially those conventional computer models may not reproduce the realistic driving behavior of interacting vehicles. An autonomously driving vehicle trained by a conventional computer model of driving behavior thus may not be able to interact properly with vehicles of a public road traffic. This can lead to dangerous driving maneuvers or accidents, especially in traffic areas like merging lanes or on-/off-ramps of highways, where the autonomously driving vehicle may interact with other vehicles.

Document US 2019/035275 A1 relates to a concept for configuring an autonomous operation capability. This concept provides for producing a state value function based on a first dataset relating to a plurality of vehicles and including a passive environmental dynamic dataset including one of simulation data and data previously collected from one or more sensors of the vehicle and stored in a memory, the first dataset including present state data and next state data. Also, this concept proposes to optimize a policy control gain based on a second dataset relating to a portion of the plurality of vehicles and including state cost data and control dynamics data. Further, this concept provides that the autonomous vehicle capability generates an autonomous vehicle action for progressing to a next state based on the state value function in cooperation with the policy control gain.

Document US 2019/0072966 A1 relates to a concept for trajectory planning of autonomous vehicles which provides for receiving training data and ground truth data from a training data collection system. The training data includes perception data and context data corresponding to human driving behaviors. Also, the concept provides for performing a training phase for training a trajectory prediction module using the training data.

Therefore, it can be considered as an object of the present disclosure to provide an improved computer model of driving behavior reproducing the realistic driving behavior.

## Summary

This object can be achieved by systems, apparatuses and methods in accordance with the independent claims. Further embodiments which may be beneficial under specific circumstances are addressed by the dependent claims.

According to a first aspect, a system for determining a computer model of realistic driving behavior comprises one or more environmental sensors which are configured to provide sensor data of observed vehicles within a traffic area. One or more position sensors installed on the observed vehicles provide positional data of the observed vehicles. A processor is configured to extract observed vehicle behavior data from the sensor data and to extract driving behavior training data from observed vehicle behavior data of vehicles interacting with each other within the traffic area. The processor determines at least one error model by comparing the positional data with the sensor data of the one or more environmental sensors. The system further comprises a machine learning based driving behavior simulator, which is configured to adjust driving behavior model parameters. The driving behavior model parameters is determined by reducing a deviation between the driving behavior training data modified by the at least one error model and simulated vehicle behavior data, which is generated by the machine learning based driving behavior simulator.

The one or more environmental sensors can be, for example, radar, light detection and ranging (LIDAR) sensors and/or cameras. Radar and/or LIDAR sensors, for example, may scan the traffic area and the observed vehicles within the traffic area to provide the sensor data. In order to observe driving behavior of interacting vehicles the traffic areas can be, for example, on-/off-ramps of highways, intersections or merging lanes.

In some example embodiments of the system, the observed vehicle behavior data is indicative of observed vehicle driving trajectories, the driving behavior training data is indicative of observed driving trajectories of vehicles interacting with each other within the traffic area, and the simulated vehicle behavior data is indicative of simulated vehicle driving trajectories. A driving trajectory can be considered as a list of coordinates describing a path along which a vehicle moves within the observed traffic area. The trajectory, further, can comprise time information. The observed traffic area can be any geographical area of interest, such as, for example, a road crossing, a road exit, merging lanes, or a combination thereof.

The sensor data can include measurement samples indicating a direction and a distance between a measurement object and the environmental sensors. A processor, which can be a central processing unit (CPU), a field-programmable gate array (FPGA), a micro controller or a programmable hardware device, can be configured to assign the measurement samples to the respective observed vehicles and to determine the observed driving trajectories including a position and a velocity of the observed vehicles from the sensor data. The observed vehicle behavior data comprises those observed driving trajectories.

Since the computer model of realistic driving behavior can focus on observing and reproducing the driving behavior of vehicles interacting with each other, the processor extracts the observed driving trajectories of those interacting vehicles. For example, interacting vehicles can be vehicles with crossing or merging trajectories. Further, interacting vehicles can be vehicles with trajectories approaching each other to a sufficient extent. The processor, for example, can take into account a distance between the trajectories and whether the observed driving trajectories intersect and/or whether there is any correlation of the velocities of the observed driving trajectories. For example, when the vehicles enter the on-ramp of the highway they may need to accelerate, decelerate and/or to change lanes depending on a driving behavior of the surrounding traffic participants. Such signatures (e.g. acceleration, deceleration, lane change) of interactions between the interacting vehicles and the respective observed driving trajectories can be detected by the processor. Thus, the processor can extract sets of observed driving trajectories of interacting vehicles. A set of observed driving trajectories of interacting vehicles may include successive observed driving trajectories of a route of individual vehicles, the successive observed driving trajectories indicating the position, the velocity and an orientation of the vehicles at successive times of measurement. By analyzing the successive observed driving trajectories of the individual vehicles, the processor can assign actions to the successive observed driving trajectories, which are performed by the vehicles at the successive times of measurement to yield subsequent observed driving trajectories. Resulting state-action pairs comprising the observed driving trajectories and the assigned actions can be used as driving behavior training data for training the machine learning based driving behavior simulator.

In some embodiments, the machine learning based driving behavior simulator can be a neural network (e.g. a recurrent neural network (RNN) or feedforward neural networks). The neural network can generate simulated vehicle behavior data, which may comprise a simulated set of trajectories comprising positions, velocities and orientations of virtual vehicles. The simulated vehicle behavior data is indicative of driving behavior model parameters. The driving behavior model parameters act as a policy which is used by the simulator when generating the simulated vehicle behavior data of virtual vehicles.

For example, the simulated vehicle behavior data can comprise simulated state-action pairs comprising sets of simulated successive trajectories and simulated actions being indicative of simulated routes of the virtual vehicles. The driving behavior model parameters can characterize the set of simulated state-action pairs by determining the simulated actions associated with the trajectories. The actions in turn affect subsequent trajectories.

The neural network performs a comparison of the simulated vehicle behavior data and the driving behavior training data. By comparing the simulated vehicle behavior data with the driving behavior training data, a deviation of the simulated vehicle behavior data and the driving behavior training data can be determined by means of the neural network. For example, in so-called behavioral cloning this deviation can be a deviation of a trajectory of the simulated vehicle behavior data from a trajectory of the driving behavior training data.

Behavioral cloning is a recursive method for adjusting the driving behavior model parameters by reducing the deviation between the simulated vehicle behavior data and the driving behavior training data. As described below, further algorithms, such as inverse reinforcement learning (IRL), reinforcement learning (RL) or generative adversarial imitation learning (GAIL), can also be used to adjust the driving behavior model parameters in such a manner that the simulated vehicle behavior data approximates the driving behavior training data.

The machine learning based driving behavior simulator can be configured to generate simulated vehicle behavior data of multiple virtual vehicles according to the adjusted driving behavior model parameters. Thus, the computer model of realistic driving behavior can be generated, based on the simulated vehicle behavior data of multiple virtual vehicles.

In some example embodiments the environmental sensors comprise one or more stationary first environmental sensors to provide first sensor data and one or more second environmental sensors installed on the observed vehicles to provide second sensor data.

Both, the first and the second environmental sensors can be, for example, cameras, lidar- or radar sensors providing sensor data, which are indicative of a 3-dimensional image of the surrounding of the observed vehicles. For example, the first environmental provide first sensor data and the second environmental sensors provide second sensor data.

Since the first and the second environmental sensors may have different reference systems, the first and the second sensor data cannot be associated with each other directly.

In some example embodiments, the processor is further configured to map the first sensor data from its reference system to a reference system of the second sensor data by comparing the first and the second sensor data with the positional data.

Mapping the first sensor data to the reference system of the second sensor data may enable to associate the mapped first and the second sensor data. Since the positional data indicate an absolute geographical position, the processor can use the positional data as a global reference for the mapping.

In some example embodiments, the processor can be further configured to determine a first error model by comparing the mapped first sensor data with the positional data and to determine a second error model by comparing the second sensor data with the positional data. The processor further can be configured to extract first observed vehicle behavior data from the mapped first sensor data, to extract first driving behavior training data from the first observed vehicle behavior data of vehicles interacting with each other within the traffic area, to extract second observed vehicle behavior data from the second sensor data and to extract second driving behavior training data from the second observed vehicle behavior data of vehicles interacting with each other within the traffic area. For modifying the first driving behavior training data the processor can apply the first error model to the first driving behavior training data. Further, the processor can be configured to modify the second driving behavior training data by applying the second error model to the second driving behavior training data. The processor can be further configured to generate the driving behavior training data modified by the first and second error model by mapping the modified first and the second driving behavior training data onto each other.

Using the positional data as ground truth, the processor can determine the first and the second error model comparing the respective mapped first and second sensor data with the positional data. A deviation between the positional data and the mapped first, respectively between the positional data and the second sensor data can be considered to generate the first and the second error model. The first and the second error model can comprise a probability distribution, which can be applied to the first and the second driving behavior data resulting, similarly as mentioned above, from the mapped first and the second sensor data. Therefore, the first and the second driving behavior training data can be indicative of the probability distribution, which can be for example a Gaussian distribution with a standard deviation. The standard deviation can be indicative of a measurement accuracy of the respective first or second environmental sensors. Alternatively, the first and/or the second error model can comprise other probability distribution, such as the Poisson distribution.

In order to apply the computer model of realistic driving behavior, for example, to autonomously driving vehicles equipped with the second environmental sensors, the computer model of realistic driving behavior can be derived from driving behavior training data modified by the first and the second error model. The driving behavior training data modified by the first and the second error model can, for example, include probability distributions of the first driving behavior training data, the second driving behavior training data or a combination thereof, which can be mapped onto each other in such a way that they match, for example, regarding peak positions. Additionally or alternatively the modified first 1010 and the modified second driving behavior training data 1020 can be mapped onto each other by applying the second error model to the modified first driving behavior training data or vice versa. Those driving behavior training data modified by the first and the second error model, thus, for example, may take into account measurement uncertainties of the second environmental sensors, which allows to generate a computer model of realistic driving behavior considering a perspective of the autonomously driving vehicle.

In some example embodiments of the system, the machine learning based driving behavior simulator is configured to generate a reward function based on the driving behavior training data. An output of the reward function indicates a similarity between the driving behavior training data and simulated vehicle behavior data input to the reward function. The machine learning based driving behavior simulator can be configured to determine improved simulated vehicle behavior data by increasing the output of the reward function for the simulated vehicle behavior data and to determine the driving behavior model parameters from the improved simulated vehicle behavior data.

The driving behavior simulator can determine the reward function from the driving behavior training data by using inverse reinforcement learning. The reward function indicates a desirability of simulated state-action pairs and can be derived from driving behavior model parameters, which can be determined from the driving behavior training data by inverse reinforcement learning. The reward function can be applied to the sets of simulated successive state-action pairs. The more similar the sets of simulated successive state-action pairs are to successive state-action pairs of the driving behavior training data, the higher can be the desirability and, thus, an output of the reward function for the sets of simulated successive state-action pairs.

The driving behavior simulator can determine the improved simulated vehicle behavior data causing a maximal output of the reward function. The improved simulated vehicle behavior data can comprise simulated vehicle behavior data being indicative of simulated routes of multiple virtual vehicles. The driving behavior simulator can adjust the driving behavior model parameters by applying reinforcement learning to the improved simulated vehicle behavior data. Those driving behavior model parameters can be used to simulate multiple virtual vehicles interacting with each other in a computer model of realistic driving behavior.

The skilled person having benefit from the present disclosure will appreciate that the driving behavior simulator using inverse reinforcement learning and reinforcement learning can provide sufficient driving behavior model parameters even, if the coverage of the driving behavior training data is not sufficient enough, for example, for behavioral cloning.

Further, reinforcement learning yields a maximal output of the reward function with respect to the multiple successive state-action pairs of one simulated route. Thus, reinforcement learning is appropriate to provide optimal long-term predictions of the simulated routes of the virtual vehicles.

In some example embodiments of the system, the machine learning based driving behavior simulator is configured to provide a discriminator having a failure rate for distinguishing between the driving behavior training data and the simulated vehicle behavior data. The machine learning based driving behavior simulator is further configured to adjust the driving behavior model parameters to cause the failure rate for distinguishing between the driving behavior training data and the simulated vehicle behavior data to increase.

According to GAIL, the discriminator can be trained to distinguish between the driving behavior training data and the simulated vehicle behavior data with the failure rate. For example the discriminator can be trained with the driving behavior training data.

Thus, the discriminator can distinguish between simulated successive state-action-pairs and observed successive state-action pairs, if the deviation between those different state-action-pairs exceeds a threshold.

By adjusting the driving behavior model parameters, the driving behavior simulator can generate simulated vehicle behavior data being indistinguishable from the driving behavior training data for the discriminator. Optimal driving behavior model parameters may yield a maximal failure rate.

The more driving behavior training data can be provided to train the discriminator, the more realistic is the computer model of realistic driving behavior, which can be generated by using GAIL.

As experience shows, GAIL can be an appropriate method to generate sufficient long- and short-term predictions regarding simulated vehicle behavior data.

In some example embodiments of the system, the machine learning based driving behavior simulator is configured to adjust the driving behavior model parameters to cause a norm of the deviation between the simulated vehicle behavior data and the driving behavior training data to decrease recursively.

For example, by behavioral cloning, the driving behavior simulator can adjust the driving behavior model parameters in successive recursion steps. In a recursion step of the behavioral cloning, a trajectory of the simulated vehicle behavior data can be predicted taking into account a simulated trajectory and driving behavior model parameters of a previous recursion step. The norm of a difference between the predicted trajectory and an observed trajectory of the driving behavior training data is indicative of a conformity of the predicted trajectory with the observed trajectory. Using an optimization process, the driving behavior simulator can adjust the driving behavior model parameters in order optimize the conformity of a subsequently predicted trajectory of a subsequent recursion step with a subsequent observed trajectory. Thus, the driving behavior model parameters can be improved with a series of recursion steps. Those driving behavior model parameters can be used, for example, to generate simulated vehicle behavior data of multiple virtual vehicles of the computer model of realistic driving behavior.

Behavioral cloning can be appropriate to make short-term predictions regarding the simulated vehicle driving behavior. For example, behavioral cloning only predicts the subsequent trajectory of the simulated virtual vehicle of the computer model of realistic driving behavior. Therefore, behavioral cloning can be particularly suitable to simulate short-term interactions (e.g. emergency brakes or evasion maneuvers) of the virtual vehicles of the computer model of realistic driving behavior.

In some example embodiments of the system of any of the previous claims, wherein the traffic area comprises a first traffic area and a second traffic area. The first traffic area can be monitored by at least one first environmental sensor and the second traffic area can be monitored by at least one second environmental sensor.

Interactions between the vehicles can be dependent of traffic situations being enclosed by the traffic area. In traffic situations at intersections, for example, human drivers of the vehicles may need to brake and stop the vehicle to give right of way to another vehicle. In traffic situations at merging lanes, for example, the human drivers may focus on keeping a sufficient distance to surrounding vehicles while changing lanes. Since the computer model of realistic driving behavior should cover a plurality of interactions between the vehicles, it can be advantageous to monitor the first and the second traffic area enclosing different traffic situations. For example, the first traffic area can be an intersection and the second traffic area can be the on-ramp of the highway.

The first and the second environmental sensor, for example, can be Lidar sensors or cameras. In advantageous example embodiments, the first and/or the second traffic area can be monitored by different types of sensors (e.g. Lidar sensors and cameras). The skilled person having benefit from the present disclosure will appreciate that using different types of sensors may increase a spatial resolution of the sensor data, for example, especially with regard to a spatial resolution reduced by challenging conditions (e.g. weather conditions). For example, the Lidar sensors can provide sufficiently good sensor data having a low signal-to-noise ratio during foggy weather conditions.

In some example embodiments, the first environmental sensor and the second environmental sensor are positioned along a route for tracking vehicles driving along the route.

For example, the first and the second environmental sensor can be located along a course of a road to track the vehicles driving on the road. The road can be, for example, the highway, a rural road or an urban road. The sensor data collected by the first and the second environmental sensor can be associated. Thus, the sensor data can be indicative of a long-term driving behavior of the vehicles, for example, to monitor the realistic driving behavior of the vehicles after they changed lanes or to monitor the long-term driving behavior of the vehicles when dynamically changing traffic signs display different speed limits depending on the traffic situation (e.g. slow-moving traffic, traffic jam, dense traffic) along the course.

Thus, the computer model of realistic driving behavior can represent a realistic long-term driving behavior of the vehicles.

In some example embodiments of the system, the first environmental sensor and the second environmental sensor have an overlapping field of view and the processor is configured to generate vehicle behavior data of a vehicle moving from a field of view of the first environmental sensor to a field of view of the second environmental sensor.

For example, the first and the second environmental sensors can be positioned along a road course. An overlap area of the traffic area can be enclosed by the overlapping field of views. Matching sensor data of a single vehicle within this part of the traffic area can be assigned to single vehicles and associated. Those sensor data may be indicative of the realistic long-term driving behavior of the single vehicles.

The sensor data of environmental sensors having overlapping fields-of-view can yield more successive state-action pairs of the single vehicles, which can be beneficial for determining reward functions indicating the long-term realistic driving behavior.

In some example embodiments of the system, the processor is further configured to classify vehicles regarding their vehicle type based on the sensor data.

The sensor data may be indicative of multiple features of the vehicle. Those can be indicative of a vehicle constitution determined by, for example, a surface condition, material, color or dimensions of the vehicle. For example, if an angular resolution of the environmental sensor is sufficiently good to resolve dimensions of the vehicles, machine learning based driving behavior simulator can determine a length and/or a height and/or a width of the vehicles from the sensor data. Thus, taking into account the dimensions (e.g. the length, the width and the height) the processor can classify the vehicles regarding their vehicle types (e.g. motorcycle, car, truck or bus). For example, if the vehicle has a width, larger than those of a motorcycle, and a height, lower than those of a truck, the processor may identify the vehicle as a car. Similarly, sensor data from trucks, buses and motorcycles can also be classified.

Thus, with respect to the sensor data of the different vehicle types, the machine learning based driving behavior simulator can generate individual driving behavior model parameters. Considering the individual driving behavior model parameters, the system can generate individual simulated vehicle behavior data for the different vehicle types of the vehicles of the computer model of realistic driving behavior.

The system further comprises one or more position sensors of the vehicles providing positional data of the vehicles. The processor of the system is further configured to determine an error model by comparing the positional data with the sensor data of the one or more environmental sensors. The processor provides the error model to the machine learning based driving behavior simulator.

The vehicles are equipped with the position sensors. The position sensors can be, for example, differential global positioning system (dGPS) sensors or inertial measurement unit (IMU) sensors. The position sensors provide the positional data as ground truth data to the processor. The positional data can be synchronized with the sensor data so that the positional data and the simultaneously measured sensor data of one of the vehicles can be compared with each other. A spatial deviation of the sensor data from the positional data indicates measurement accuracy of the environmental sensors.

The error model can apply a probability distribution to the driving behavior training data taking into account the measurement accuracy. The positions, velocities and the orientation of the observed driving trajectories extracted from the sensor data, thus, can be represented, for example, as Gaussian functions with a standard deviation being indicative of the measurement accuracy and a peak of the Gaussian function being located at the position of the observed driving trajectories.

The skilled person having benefit from the present disclosure will appreciate that the error model can provide a measure of contribution of the sensor data to a resulting computer model of realistic driving behavior. For example, less precise sensor data can be weighted less for determining the realistic driving behavior.

According to a second aspect, an apparatus for determining a computer model of realistic driving behavior comprises a machine learning based driving behavior simulator. The machine learning based driving behavior simulator is configured to adjust driving behavior model parameters by reducing a deviation between the driving behavior training data modified by at least one error model and simulated vehicle behavior data generated by the machine learning based driving behavior simulator. The driving behavior training data is extracted from observed vehicle behavior data of vehicles interacting with each other within a traffic area. The observed vehicle behavior data is extracted from sensor data. The sensor data of observed vehicles within a traffic area is generated using one or more environmental sensors. The at least one error model is determined by comparing positional data with the sensor data of the one or more environmental sensors; and the positional data of the observed vehicles provided by one or more position sensors installed on the observed vehicles.

The apparatus, for example, may comprise a processor and/or a neural network which can determine the driving behavior model parameters from the driving behavior training data being derived from the sensor data of the environmental sensors of the system. The driving behavior model parameters can be determined similarly regarding previously described example embodiments of the system.

According to a third aspect, an apparatus for providing the driving behavior training data for a machine learning based driving behavior simulator comprises one or more environmental sensors configured to provide sensor data of observed vehicles within a traffic area. The apparatus further comprises one or more position sensors installed on the observed vehicles providing positional data of the observed vehicles. Further, the apparatus comprises one or more processors configured to determine at least one error model by comparing the positional data with the sensor data of the one or more environmental sensors. The processor is further configured to extract observed vehicle behavior data from the sensor data and to extract the driving behavior training data from observed vehicle behavior data of vehicles interacting with each other within the traffic area. The driving behavior training data modified by the at least one error model can be used for adjusting model parameters of the machine learning based driving behavior simulator by reducing a deviation between the driving behavior training data and simulated vehicle behavior data generated by the machine learning based driving behavior simulator.

The apparatus, for example, may comprise a processor and at least one environmental sensor which provides sensor data to the processor. The processor can derive observed vehicle behavior data from the sensor data and subsequently the processor can derive driving behavior training data from the observed vehicle behavior data of the interacting vehicles. The driving behavior model parameters can be determined, for example, by the neural network of the system similarly regarding previously described example embodiments of the system.

According to a fourth aspect, a method for determining a computer model of realistic driving behavior intends to provide the sensor data of observed vehicles within a traffic area using one or more environmental sensors and to provide positional data of the observed vehicles using one or more position sensors installed on the observed vehicles. Further, observed vehicle behavior data is extracted from the sensor data and driving behavior training data is extracted from observed vehicle behavior data of vehicles interacting with each other within the traffic area. The method intends to determine at least one error model by comparing the positional data with the sensor data of the one or more environmental sensors The method further intends to adjust model parameters of the machine learning based driving behavior simulator by reducing a deviation between the driving behavior training data modified by the at least one error model and simulated vehicle behavior data generated by the machine learning based driving behavior simulator.

The method can be used, for example, in previously described example embodiments of the system for determining a computer model of realistic driving behavior. The sensor data can be provided by the environmental sensors. The processor and/or the neural network, for example, can execute a program code to process the sensor data of the one or more environmental sensors to adjust the driving behavior model parameters.

According to a fifth aspect, a method for determining a computer model of realistic driving behavior prescribes to adjust model parameters of a machine learning based driving behavior simulator by reducing a deviation between driving behavior training data modified by at least one error model and simulated vehicle behavior data. Those are generated by the machine learning based driving behavior simulator. The driving behavior training data are extracted from observed vehicle behavior data of vehicles interacting with each other within a traffic area. The observed vehicle behavior data are extracted from sensor data and the sensor data of observed vehicles within a traffic area are generated using one or more environmental sensors. The at least one error model is determined by comparing positional data with the sensor data of the one or more environmental sensors. The positional data of the observed vehicles is generated using one or more position sensors installed on the observed vehicles.

The method can be executed by the processor and/or the neural network to determine a computer model of realistic driving behavior which, for example, may simulate multiple virtual vehicles acting according to the driving behavior model parameters. The driving behavior model parameters can be derived from the driving behavior training data by executing the method. The driving behavior training data can be extracted from the observed vehicle behavior data which can be derived from the sensor data of the one or more environmental sensors of the system.

According to a sixth aspect, a method for providing driving behavior training data for a machine learning based driving behavior simulator prescribes to provide sensor data of observed vehicles within a traffic area using one or more environmental sensors. The method further intends to provide positional data of the observed vehicles using one or more position sensors installed on the observed vehicles. Observed vehicle behavior data is extracted from the sensor data. The method further intends to extract the driving behavior training data from observed vehicle behavior data of vehicles interacting with each other within the traffic area. The method further intends to determine at least one error model by comparing the positional data with the sensor data of the one or more environmental sensors. The driving behavior training data can be used for adjusting model parameters of the machine learning based driving behavior simulator by reducing a deviation between the driving behavior training data modified by the at least one error model and simulated vehicle behavior data generated by the machine learning based driving behavior simulator.

The skilled person having benefit from the present disclosure will appreciate that the method can be executed by the previously described system or the apparatus for providing driving behavior training. The system, for example, is configured to execute the method to provide the driving behavior training data in order to adjust the driving behavior model parameters using a machine learning based driving behavior simulator.

In some example embodiments, the method further intends to provide positional data of the vehicles, by one or more position sensors of the vehicles. The method further prescribes to determine an error model by comparing the positional data with the sensor data of the one or more environmental sensors, wherein the error model can be used for adjusting the model parameters of the machine learning based driving behavior simulator.

The example embodiments of the method, which can, for example, be executed by the previously described system, can achieve beneficial effects which have been mentioned in the context of this system.

**Brief description of the Figures**

Some examples of apparatuses and/or methods will be described in the following by way of example only, and with reference to the accompanying figures, in which,

Fig. 1    illustrates the system for determining a computer model of realistic driving behavior with the processor, the machine learning based driving behavior simulator and the environmental sensor monitoring the traffic area;

Fig. 2    illustrates the method for determining a computer model of realistic driving behavior;

Fig. 3    shows block diagrams illustrating the inverse reinforcement learning (top) and the reinforcement learning (bottom);

Fig. 4    depicts a block diagram illustrating the behavioral cloning;

Fig. 5    shows a block diagram illustrating the generative adversarial imitation learning (GAIL);

Fig. 6    shows a block diagram illustrating a process for providing driving behavior training data using one or more cameras and a radar/lidar sensor;

Fig. 7    illustrating a first and a second environmental sensor monitoring a first and a second traffic area;

Fig. 8    illustrating the first and the second environmental sensor having overlapping field of views;

Fig. 9    shows a diagram illustrating a distance dependence of the error model; and

Fig. 10    illustrating the modified first and the modified second driving behavior training data as Gaussian distributions.

**Detailed Description**

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Same or like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

Conventional computer models of driving behavior do not take into account measurement data of (real) vehicles interacting with other (real) vehicles. Thus, conventional computer models can be based on predefined model parameters, which determine a driving behavior of virtual vehicles of the conventional computer models. Therefore, the driving behavior of the virtual vehicles of the conventional computer models do not reproduce a realistic driving behavior of the real vehicles. Autonomous driving systems or ego-agents (virtual vehicles), which are trained by such computer models, thus, cannot reproduce the realistic driving behavior, especially with regard to interactions with the (real) vehicles. Thus, example embodiments of the present disclosure provide a computer model of realistic driving behavior.

In order to determine the computer model of realistic driving behavior, a system can take into account sensor data being indicative of the realistic driving behavior of the (real) vehicles.

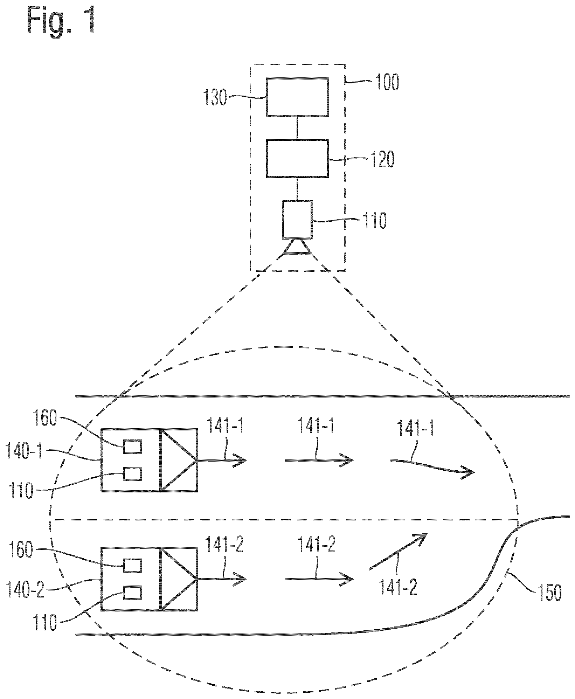

Fig. 1 illustrates a system 100 for determining the computer model of realistic driving behavior. The system comprises one or more environmental sensors 110, which, for example, can be a camera, a radar or a lidar sensor. The one or more environmental sensors 110, for example, can be stationary and/or installed on vehicles 140-1 and/or 140-2 and can monitor a traffic area 150 enclosed by a field of view of the environmental sensor 110. With regard to Fig. 1, the traffic area 150 can comprise a traffic situation with the vehicles 140-1 and 140-2, which interact at merging lanes. The environmental sensors 110 can provide sensor data being indicative of distances of the vehicles 140-1 and 140-2 to the environmental sensors 110 at successive times of measurement. The environmental sensors 110 provide the sensor data, which are indicative of observed driving trajectories 141-1 and 141-2 of the vehicles 140-1 and 140-2, to a processor 120. The processor 120 filters and processes the sensor data for the machine learning based driving behavior simulator 130, which is coupled with the processor 120. The machine learning based driving behavior simulator 130 can comprise, for example a neural network, such as a recurrent neural network (RNN).

As shown in Fig. 1, the vehicles 140-1 and 140-2 further are equipped with position sensors 160, which can provide positional data of the vehicles 140-1 and 140-2 to the processor for generating at least one error model. The positional data can be indicative of a geographical position of the vehicles 140-1 and 140-2. The position sensors 160 can be, for example, dGPS or IMU sensors. Using the positional data as ground truth, the processor can determine a deviation between the positional data and the sensor data. The deviation can be indicative of the measurement accuracy of the environmental sensors 110. Thus, the processor may determine different error models, which may relate to different environmental sensors 110. For example, the error model of the stationary environmental sensors may be different from the environmental sensors installed on the vehicles 140-1 and 140-2.

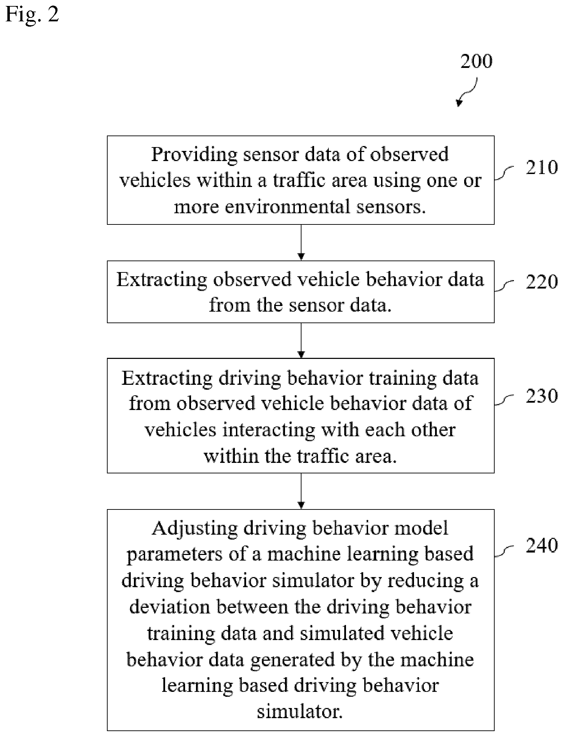

The system 100 can execute a method 200 according to Fig. 2 for determining the computer model of realistic driving behavior.

The environmental sensors 110 provide 210 the sensor data of observed vehicles (e.g. the vehicles 140-1 and 140-2) within the traffic area 150. The environmental sensors transmit the sensor data to the processor 120. The processor extracts 220 observed vehicle behavior data from the sensor data. The observed vehicle behavior data is indicative of observed driving trajectories 141-1 and 141-2, which are determined by the processor 120 from the sensor data. The observed driving trajectories 141-1 and 141-2 comprise, for example, positions, velocities, orientations and the times of measurement.

Conventional computer models can reproduce the realistic driving behavior of the (real) vehicles as long as they do not interact with each other. Thus, it can be considered as a task of example embodiments of the present disclosure to generate an improved computer model of realistic behavior, which can also reproduce the realistic driving behavior of interacting (real) vehicles. Therefore, the processor 120 extracts 230 driving behavior training data from the observed driving trajectories 141-1 and 141-2 of interacting vehicles, such as the vehicles 140-1 and 140-2. The processor 120 extracts the trajectories 141-1 and 141-2, if they indicate signatures of interaction between the vehicles 140-1 and 140-2. For example, a distance between the positions of the observed driving trajectories 141-1 and 141-2 can indicate an interaction between the vehicles 140-1 and 140-2. Also, intersecting observed driving trajectories can be indicative of the interaction between the vehicles 140-1 and 140-2. The resulting driving behavior training data comprises sets of successive observed driving trajectories of the interacting vehicles 140-1 and 140-2. A set of successive trajectories is assigned to a route of the respective vehicle 140-1 or 140-2.

The processor 120 further assigns actions to the observed driving trajectories of the driving behavior training data. The actions indicate parameters of change acting on one observed driving trajectory of the vehicle 140-1 or 140-2 to yield a subsequent trajectory of the route of the vehicle 140-1, respectively 140-2. For example, the actions can act on the velocity of one observed driving trajectory (acceleration in driving direction) or on the orientation of one observed trajectory (rotation). Resulting state-action pairs comprising the observed driving trajectories and the assigned actions can be used as driving behavior training data for training the machine learning based driving behavior simulator.

The state-action pairs are forwarded to the machine learning based driving behavior simulator to adjust 240 model parameters of the machine learning based driving behavior simulator by reducing a deviation between the driving behavior training data and simulated vehicle behavior data generated by the machine learning based driving behavior simulator.

In order to determine a deviation between the simulated vehicle behavior data and the driving behavior training data, the simulated vehicle behavior data also comprises simulated state-action pairs with simulated trajectories and corresponding simulated actions. The simulated state-action pairs are generated by the neural network 130 according to driving behavior model parameters, which initially can be determined from the driving behavior training data, for example. The driving behavior model parameters can, for example, determine the action to a corresponding driving behavior trajectory 141-1 or 141-2 to yield the subsequent trajectory, which is assumed as optimal according to the driving behavior model parameters.

The neural network 130 further determines the deviation between the simulated vehicle behavior data and the driving behavior training data. By using an optimization process, the neural network 130 adjusts 240 the driving behavior model parameters to minimize the deviation between the simulated vehicle behavior data and the driving behavior training data. Those adjusted driving behavior model parameters can be used to generate simulated vehicle behavior data of the virtual vehicles of the computer model of realistic driving behavior.

The neural network 130 can use various optimization processes to adjust the model parameters and to generate the simulated vehicle behavior data of the virtual vehicles. The optimization process can be, for instance, a combination of inverse reinforcement learning and reinforcement learning, generative adversarial imitation learning or behavioral cloning.

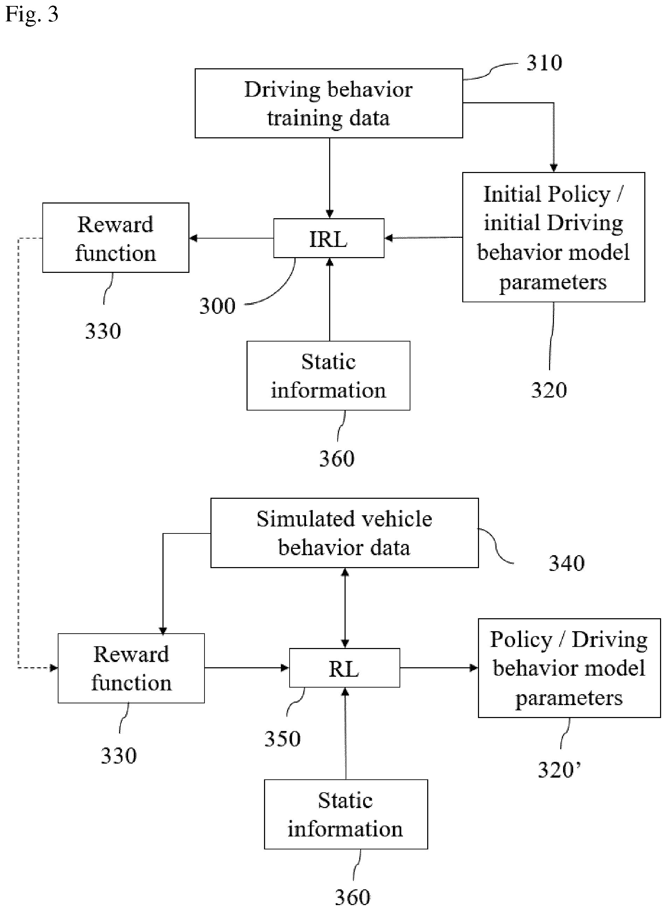

Fig. 3 illustrates one of the various optimization processes, which is a combination of inverse reinforcement learning 300 and reinforcement learning 350.

This optimization process intends to derive a reward function 330 from the driving behavior training data 310 and an initial policy 320, which is indicative of initial driving behavior model parameters 320, by using inverse reinforcement learning 300 (Fig. 3 top). The initial driving behavior model parameters 320 initially can be determined by the neural network from the driving behavior training data 310 by using reinforcement learning. However, in further example embodiments, the initial driving behavior model parameters 320 can be obtained from static information 360 (e.g. a map) being indicative of the traffic area 150.

The reward function 330 indicates a desirability of the simulated trajectories according to the initial driving behavior model parameters 320 and can be used for reinforcement learning 350 (Fig. 3, bottom). The larger an output of the reward function 330 applied to the simulated successive trajectories of the simulated vehicle behavior data 340, the more ideal is the route of simulated successive trajectories according to the initial policy 320.

Using reinforcement learning 350, the neural network 130 generates the simulated vehicle behavior data 340 comprising sets of simulated successive trajectories, which yield a maximal output, if the reward function 330 is applied to them.

Using reinforcement learning 350 the neural network 130 optimizes the initial policy 320 to determine an adjusted policy 320'. With the adjusted policy 320', the neural network 130 can generate improved simulated vehicle behavior data of multiple virtual vehicles of the computer model of realistic driving behavior. The possible positions included in the simulated vehicle behavior data can be limited to positions, which are allowed according to the static information 360. For example, the simulated vehicle behavior data of the virtual vehicles may not include any positions next to a road which can be mapped in the static information 360. The adjusted policy can be determined according to:

$$R(\pi, r) = E_\pi \left[ \sum_{t=0}^{T} \gamma^t r(s_t, a_t) \right],$$

wherein $R(\pi, r)$ indicates the adjusted policy 320', $E_\pi$ the initial policy 320, $\gamma$ a discount factor and $r(s_t, a_t)$ the reward function 330 applied to the state-action pairs $(s_t, a_t)$ of time t.

The reward function 330 can be suitable to adjust the driving behavior model parameters for an individual traffic situation (here: merging lanes) enclosed by the monitored traffic area 150. But, for example, the reward function 330 is adaptable and can be transferred to similar traffic situations. For example, the reward function 330 can be applied and/or adapted to determine the simulated vehicle behavior data 340 with regard to other merging lanes.

The skilled person having profit of the present disclosure will appreciate that IRL and RL is capable of observing and reproducing long-term realistic driving behavior by taking into account the routes of the observed driving trajectories of the (real) vehicles.

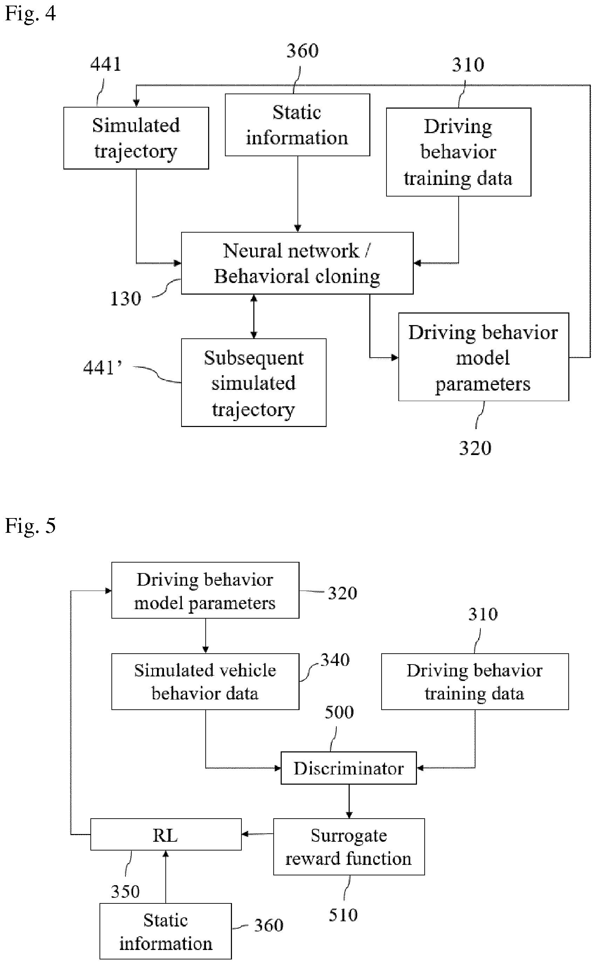

Fig. 4 illustrates behavioral cloning, which is another optimization process which can be used by the neural network 130 for adjusting the driving behavior model parameters 320. Behavioral cloning can be performed as a recursive method with multiple successive recursion steps.

In one recursion step, the neural network 130 generates a subsequent simulated trajectory 441' by acting on the simulated trajectory 441 of a previous recursion step taking into account the driving behavior model parameters 320 of the previous recursion step. The neural network 130 may also take into account the static information 360, which can be map data or information about speed limits. For example, with respect to the static information 360, the neural network 130 can pretend the calculation of trajectories which yield an exceedance of the prescribed speed limit of the traffic area 150.

The neural network 130 determines a deviation between the subsequent simulated trajectory 441' and one observed driving trajectory of the driving behavior training data 310. In case of behavioral cloning, the deviation is norm of a difference between the subsequent simulated trajectory 441' and the observed driving trajectory. In particular, but not exclusively, the norm can be the Euclidean norm or the Taxicab norm. The deviation can be considered as a measure of a conformity of the driving behavior training data 310 with the driving behavior model parameters. Thus, the neural network 130 can adjust the driving behavior model parameters 320 to yield a reduction of the deviation. Ideally, the deviation can be minimized.

The adjusted driving behavior model parameters can be used to determine a simulated action which can be assigned to the subsequent simulated trajectory 441'. The simulated action generates another subsequent simulated trajectory 441' which can be used in a subsequent recursive step of behavioral cloning. Thus, the driving behavior model parameters 320 can converge in an ideal case.

Behavioral cloning can provide abrupt changes of the driving behavior model parameters 320 during a simulation of the route of the virtual vehicles of the computer model of realistic driving. Thus, behavioral cloning can be suitable to simulate short-term driving behavior of the virtual vehicles. For example, behavioral cloning can be useful to simulate emergency brakes or emergency turns.

Fig. 5 illustrates generative adversarial imitation learning (GAIL), which can be performed by the neural network 130 of the system 100 to adjust the driving behavior model parameters 320.

A discriminator 500 can be trained by the neural network 130. The discriminator can be trained with the driving behavior training data 310 (observed state-action pairs) to distinguish simulated driving behavior from the realistic driving behavior. This means that the discriminator is capable of distinguishing between the simulated vehicle behavior data 340 (simulated state-action pairs) and the driving behavior training data 310 (observed state-action pairs) with a failure rate. The more similar the simulated state-action pairs 340 are to the observed state-action pairs 310, the higher is a probability of an erroneous classification of the observed and the simulated state-action pairs 310 and 340. Thus, the more similar the simulated state-action pairs are 340 are to the observed state-action pairs, the higher is the failure rate.

Erroneous classifications of the observed and simulated state-action pairs can be used by the neural network 130 to determine a surrogate reward function 510. Using reinforcement learning 360, the neural network 130 adjusts the driving behavior model parameters 320 similar as described previously. Again, the RL 350 can consider static information 360, to avoid generating unrealistic simulated vehicle behavior data, for example, including positions of the vehicle 140-1 and 140-2 being next to the road.

With the adjusted driving behavior model parameters 320, the neural network 130 can generate simulated vehicle behavior data of the virtual vehicles of the computer model of realistic driving behavior.

GAIL incorporating the surrogate reward function can provide a long-term prediction of multiple simulated successive trajectories without cascading errors, which may occur, for example, by using behavioral cloning.

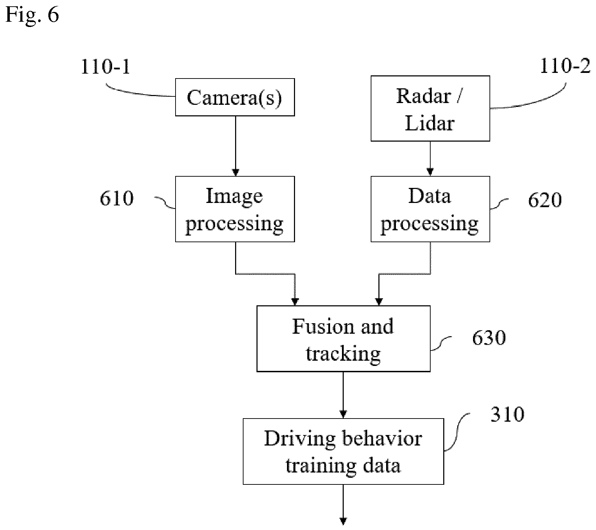

Generating the computer model of realistic driving behavior requires precise sensor data, which can be challenging, especially, in bad weather conditions (e.g. rain or fog). A performance of a camera or a lidar sensor, for example, may decrease in foggy weather conditions. Thus it may be advantageous to provide sensor data by using different types of environmental sensors. This may yield a redundancy of the sensor data of the different environmental sensors. Fig. 6 illustrates the system 100 comprising a camera 110-1 and a lidar or radar sensor 110-2. Further, a spatial resolution of the camera can be sufficient to determine dimensions of the vehicles 140-1 and 140-2, which can be useful for a classification of the vehicles 140-1 and 140-2.

The sensor data of the camera 110-1 are referred to as camera data in the following. By using image processing 610, the processor 120 recognizes the vehicles 140-1 and 140-2 within the traffic area 150 and determines camera observation data comprising, for example, the position in a road plane, the velocity, the orientation and the dimensions of the vehicles 140-1 and 140-2.

The sensor data of the lidar or radar sensor 110-2 are referred to as radar data in the following. The radar data is captured simultaneously with the camera data to ensure the camera data and the radar data to be redundant. By using data processing 620, the processor 120 clusters measurement samples of the radar data, which refer to one of the vehicles 140-1 and 140-2 being within the traffic area 150, and determines radar observation data comprising, for example, the position, the velocity and the orientation of the vehicles 140-1 and 140-2. The measurement samples can be, for example indicative of the position, the velocity or the orientation of the vehicles 140-1 and 140-2.

A fusion 630 of the camera observation data and the radar observation data generates the observed vehicle behavior data being a mean value of the camera observation data and the radar observation data. Measurement accuracies of the camera 110-1 and the radar or lidar sensor 110-2 indicate contributions to the observed vehicle behavior data. The higher the accuracy of the environmental sensor 110-1 or 110-2, the more the camera data or the radar data is weighted for a calculation of the observed vehicle behavior data.

Successively calculated observed vehicle behavior data can be assigned to a same vehicle 140-1 or 140-2 for tracking the vehicles 140-1 and 140-2. The positions, the velocities and the orientations of successively measured observed vehicle behavior data can be used to assign the successively measured observed vehicle behavior data to the observed vehicles 140-1 and 140-2 or rather to distinguish between the observed vehicle behavior data of those vehicles 140-1 and 140-2.

By using the camera observation data, the processor 120 can carry out a classification 640 of the vehicles 140-1 and 140-2. By means of image processing, the processor 120 can extract dimensions (e.g. a length, a width and a height) of the vehicles 140-1 und 140-2. Thus, the processor 120 can distinguish the vehicles 140-1 and 140-2 with regard to their vehicle type. For example, if the dimensions of the vehicle 140-1 are similar to dimensions of a bus, the processor classifies the observed vehicle behavior data of the vehicle 140-1 as those of a bus.

As mentioned previously, the processor 120 extracts the driving behavior training data 310 from the observed vehicle behavior and applies the previously described optimization processes (IRL, RL, GAIL, behavioral cloning) to the driving behavior training data 310 to adjust the driving behavior model parameters 320.

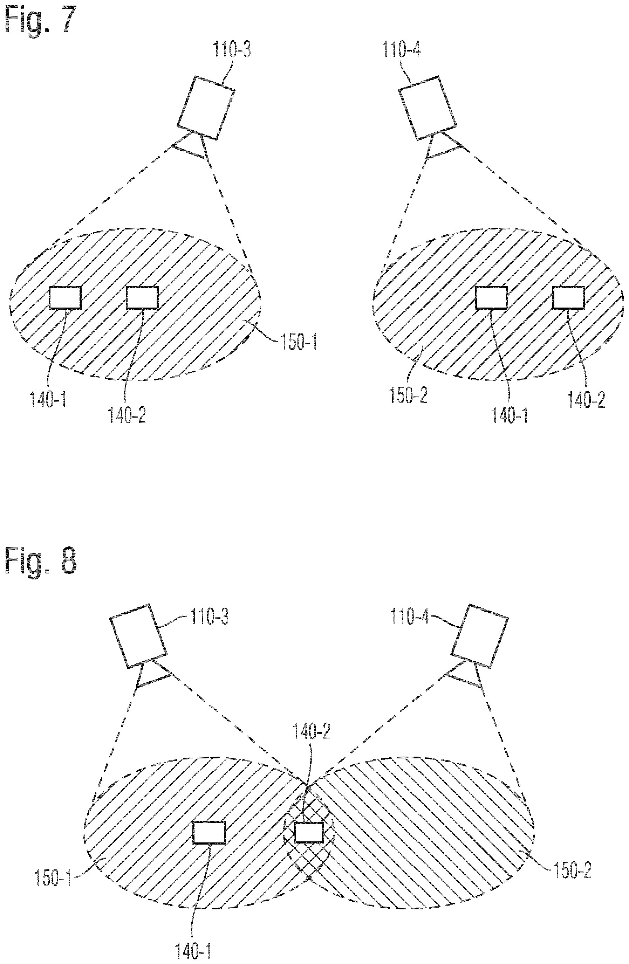

An autonomous driving system being trained with the computer model of realistic driving behavior should be able to adapt to different everyday traffic situations (e.g. an intersection or on- and off-ramps of the highway). Therefore, the driving behavior training data 310, which is indicative of the realistic driving behavior, may be extracted from the sensor data of different traffic areas enclosing different traffic situations. Fig. 7 illustrates a setup of first environmental sensors 110-3 monitoring a first traffic area 150-1 and second environmental sensors 110-4 monitoring a second traffic area 150-2. The environmental sensors can be coupled with the processor 120 to transmit the sensor data to it.

The traffic areas 150-1 and 150-2 can have different geographical locations in possibly different climate zones to observe a correlation between environmental conditions (e.g. weather conditions, road conditions, traffic code) and the realistic driving behavior. Further, the traffic areas 150-1 and 150-2 may enclose different traffic situations, such as intersections, merging lanes, on- and off ramps of highways, roundabouts, turnoffs, etc.). The sensor data of the first and the second environmental sensors 110-3 and 110-4 can be labeled with environmental information being indicative of the traffic situation and the environmental conditions. Thus, the labeled sensor data and the resulting driving behavior training data 310 can be used to reproduce different ways of realistic driving behavior considering the environmental information. The computer model of realistic driving behavior, thus, can reproduce the different ways of realistic driving behavior of the vehicles 140-1 and 140-2 interacting in different traffic situations at different weather and/or road conditions. Therefore, the autonomous driving system being trained with such a computer model of realistic driving behavior can adapt to various traffic situations in everyday traffic.

The individual observed traffic areas 150-1 and 150-2 of the environmental sensors (e.g. cameras 110-1 or lidar/radar sensors 110-2) 110-3 and 110-4 may be too small to track the vehicles 140-1 and 140-2 and to determine a long-term realistic driving behavior of the vehicles 140-1 and 140-2. Fig. 8 illustrates a setup of the first and the second environmental sensor 110-3 and 110-4 which can be capable of tracking the vehicles 140-1 and 140-2. The first environmental sensor 110-3 monitors the first traffic area 150-1 and the second environmental sensor 110-4 monitors the second traffic area 150-2. A first field of view 111-3 of the first environmental sensor 110-3 and a second field of view 111-4 of the second environmental sensor 110-4 can overlap according to Fig. 8 in such a manner that both of the environmental sensors 110-3 and 110-4 enclose an overlap area 150-3.

The environmental sensors 110-3 and 110-4, for example, can be positioned along a road course to monitor the vehicles 140-1 and 140-2 driving along the road. The vehicle 140-1 is monitored by the first environmental sensors 110-3 as long as the vehicle 140-1 is within the first traffic area 150-1. If vehicles are within the overlap area 150-3, such as the vehicle 140-2, the first and the second environmental sensors 110-3 and 110-4 both monitor the vehicles. With regard to the sensor data of the vehicle 140-2, the sensor data of the first and the second environmental sensors 110-3 and 110-4 can approximately match regarding its position, velocity, dimensions/vehicle type and/or orientation. The skilled person having benefit from the present disclosure will appreciate that matching sensor data of the environmental sensors 110-3 and 110-4 can be assigned to the vehicle 140-2. The sensor data related to the vehicle 140-2, thus, can be a compilation of the sensor data of the first and the second environmental sensors 110-3 and 110-4.

Using the environmental sensors 110-3 and 110-4 having overlapping field of views, the set of successive observed driving trajectories of the vehicles 140-1 and 140-2 can be more extended than the set of observed driving trajectories observed with a single environmental sensor 110-3 or 110-4. Such an extended set of observed driving trajectories can be used to determine a long-term realistic driving behavior of the vehicles 140-1 and 140-2.

Therefore, for example, the realistic driving behavior of the vehicles 140-1 and 140-2 can be determined before or after they interacted with each other.

The skilled person having benefit from the present disclosure will appreciate that the sensor data of the overlap area 150-3 of the environmental sensors 110-3 and 110-4 can be combined using multi-sensor data fusion processing to improve a spatial resolution of the sensor data.

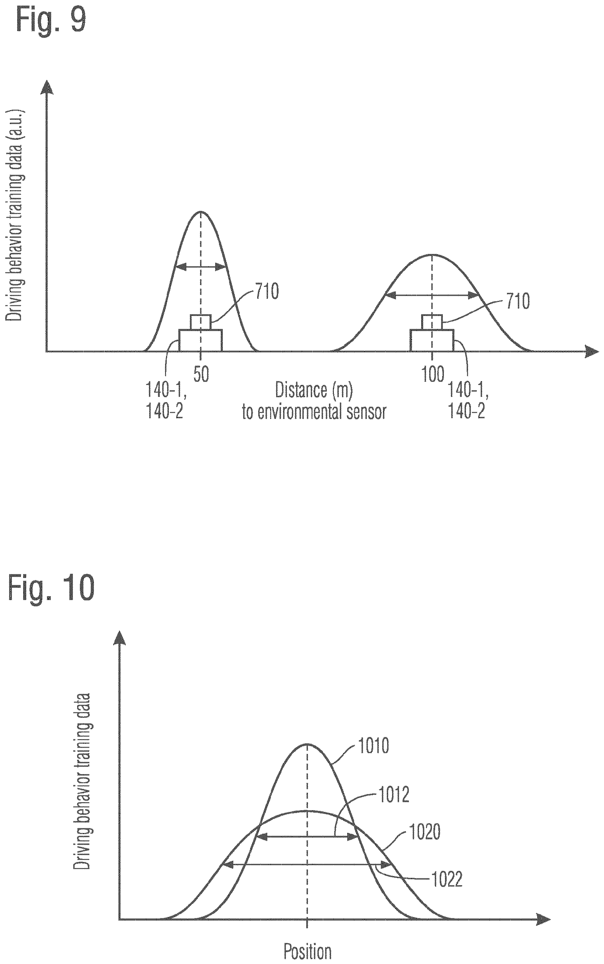

The spatial resolution of the sensor data can be dependent of a pixel pitch and a measurement accuracy of the environmental sensors 110-3 and 110-4. Typically, the measurement accuracy of the environmental sensors 110-3 and 110-4 deteriorates with an increasing distance of the vehicles 140-1 and 140-2 from the environmental sensors 110-3 and 110-4. As shown in Fig. 9, an error model can be determined from the measurement accuracy of the environmental sensors 110-3 and 110-4.

Fig. 9 illustrates a diagram and the vehicles 140-1 and 140-2 which can be equipped with the position sensors 160, as shown. The position sensors 160 can provide positional data of the vehicles 140-1 and 140-2 to the processor 120. The positional data can be time-synchronized with measurements of the environmental sensors 110-3 and 110-4. Further, the positional data being indicative of the position of the vehicles 140-1 and 140-2 can be used as ground truth data to determine the measurement accuracy of the environmental sensors 110-3 and 110-4 by comparing the positional data with the sensor data. The measurement accuracy can be indicative of a standard deviation of a probability distribution being applied to the driving behavior training data 310 to determine probabilistic driving behavior training data 310, which can be for example a Gaussian distribution. The Gaussian distribution can be, for example, a two-dimensional Gaussian function.

The distance from the environmental sensors 110-3 and 110-4 can be divided into "bins". For every "bin" a characteristic measurement accuracy and, thus, a standard deviation can be determined. The measurement accuracies regarding different dimensions can be different. Thus, measurement samples of every "bin" of the driving behavior training data 310 can be represented as two-dimensional Gaussian functions with different standard deviations along the two dimensions.

Further, second environmental sensors, for example Lidar sensors, can be installed on the vehicles 140-1 and 104-2. The first and the second environmental sensors each may have different reference systems. Those second environmental sensors provide second sensor data indicating, for example, a relative position and a relative velocity of the vehicles 140-1 and 140-2 regarding surrounding vehicles. The stationary or first environmental sensors 110 can provide first sensor data indicating, for example, an absolute position and an absolute velocity of the vehicles 140-1 and 140-2 regarding a location of the first environmental sensors. Since the first and the second environmental sensors have different reference systems, the first and the second sensor data cannot be associated with each other without mapping the first and the second sensor data in a common reference system. For instance, the processor 120 can map the first sensor data from its reference system to the reference system of the second sensor data by comparing the first and the second sensor data with the positional data. The positional data can be used as a global reference regarding the first and the second sensor data. By mapping the first sensor data in the reference system of the vehicles 140-1 and 140-2, resulting first driving behavior training data can be based on a perspective of the vehicles 140-1 and 140-2. This enables an implementation of the machine learning based driving behavior simulator in real vehicles.

Using the positional data as ground truth, the processor can obtain a first error model of the first environmental sensors and a second error model of the second environmental sensors of the vehicles 140-1 and 140-2 by comparing the positional data respectively with the first and the second sensor data.

As illustrated in Fig. 10, when applying the first and the second error model to the first driving behavior training data to generate the modified first driving behavior training data 1010 and the modified second driving behavior training data 1020, they can be represented, for example, as Gaussian functions 1010 and 1020. In Fig. 10, for example, the positions of the modified driving behavior training data are indicated by the Gaussian functions. In further example embodiments, the modified first and the modified second driving behavior training data can be represented as an alternative probability distribution, such as the Poisson distribution, due to an alternative error model.

In the illustrated example of Fig. 10, the Gaussian functions may have standard deviations 1012 and 1022 corresponding to measurement accuracies of the stationary first environmental sensors and the second environmental sensors of the vehicles 140-1 and 140-2, which can be determined by comparing the respective first and second sensor data with the positional data.

For generating the driving behavior training data modified by the first and the second error model 1010 and 1020, the modified first driving behavior training data 1010 and the modified second driving behavior training data 1020 can be mapped onto each other. For example the modified first driving behavior training data 1010 and the modified second driving behavior training data 1020 can be transformed in such a way that they match regarding their peak positions and/or their standard deviations 1012 and 1022 in their common reference systems. For example, the second driving behavior 1020 can be modified so that their peak positions correspond to peak positions of the first driving behavior training data 1010. Additionally or alternatively, for example, by applying the second error model to the first driving behavior training data 1010, they can be modified so that their standard deviation 1012 is indicative of the measurement accuracy of the second environmental sensors. This may allow to apply the computer model of realistic driving behavior to real autonomously driving vehicles.

The aspects and features mentioned and described together with one or more of the previously detailed examples and figures, may as well be combined with one or more of the other examples in order to replace a like feature of the other example or in order to additionally introduce the feature to the other example.

Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a signal", "means for generating a signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software, but may include digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

The scope of the present invention is defined in the appended claims.

**Claims**

1. A system (100) for determining a computer model of realistic driving behavior for training an autonomous driving system, the system comprising:

    one or more environmental sensors (110) configured to provide sensor data of observed vehicles (140-1, 140-2) within a traffic area (150); one or more position sensors (160) installed on the observed vehicles (140-1, 140-2) providing positional data of the observed vehicles (140-1, 140-2); a processor (120) configured to determine at least one error model by comparing the positional data with the sensor data of the one or more environmental sensors (110); extract observed vehicle behavior data from the sensor data and to extract driving behavior training data (310) from observed vehicle behavior data of vehicles (140-1, 140-2) interacting with each other within the traffic area (150); and a machine learning based driving behavior simulator (130) configured to: adjust driving behavior model parameters (320) by reducing a deviation between the driving behavior training data (310) modified by the at least one error model and simulated vehicle behavior data (340) generated by the machine learning based driving behavior simulator (130) and to train the autonomous driving system.

2. The system (100) of claim 1, wherein the environmental sensors (110) comprise one or more stationary first environmental sensors to provide first sensor data and one or more second environmental sensors installed on the observed vehicles (140-1, 140-2) to provide second sensor data.

3. The system (100) of claim 2, wherein the processor (120) is further configured to map the first sensor data from its reference system to a reference system of the second sensor data by comparing the first and the second sensor data with the positional data.

4. The system (100) of claim 3, wherein the processor (120) is further configured to:

determine a first error model by comparing the mapped first sensor data with the positional data
determine a second error model by comparing the second sensor data with the positional data;
extract first observed vehicle behavior data from the mapped first sensor data;
extract first driving behavior training data from the first observed vehicle behavior data of vehicles interacting with each other within the traffic area (150);
extract second observed vehicle behavior data from the second sensor data;
extract second driving behavior training data from the second observed vehicle behavior data of vehicles interacting with each other within the traffic area (150);
modify the first driving behavior training data by applying the first error model to the first driving behavior training data;
modify the second driving behavior training data by applying the second error model to the second driving behavior training data;
generating the driving behavior training data modified by the first and second error model by mapping the modified first and the second driving behavior training data (1010, 1020) onto each other.

5. The system (100) of claim 1, wherein the machine learning based driving behavior simulator (130) is configured to

generate a reward function (330) based on the driving behavior training data (310), an output of the reward function (330) indicating a similarity between the driving behavior training data (310) and simulated vehicle behavior data (340) input to the reward function (330),
determine improved simulated vehicle behavior data (340) increasing the output of the reward function (330) for the simulated vehicle behavior data (340), and
determine the driving behavior model parameters (320) from the improved simulated vehicle behavior data.

6. The system (100) of claim 1, wherein the machine learning based driving behavior simulator (130) is configured to

provide a discriminator (500) having a failure rate for distinguishing between the driving behavior training data (310) and the simulated vehicle behavior data (340), and
adjust the driving behavior model parameters (320) to cause the failure rate for distinguishing between the driving behavior training data (310) and the simulated vehicle behavior data (340) to increase.

7. The system (100) of claim 1, wherein the machine learning based driving behavior simulator (130) is configured to
adjust the driving behavior model parameters (320) to cause a norm of the deviation between the simulated vehicle behavior data (340) and the driving behavior training data (310) to decrease recursively.

8. The system (100) of any of the previous claims, wherein the traffic area (150) comprises a first traffic area (150-1) and a second traffic area (150-2), the first traffic area (150-1) being monitored by at least one first environmental sensor (110-3) and the second traffic area (150-2) being monitored by at least one second environmental sensor (110-4).

9. The system (100) of claim 7, wherein the first environmental sensor (110-3) and the second environmental sensor (110-4) are positioned along a route for tracking vehicles (140-1, 140-2) driving along the route.

10. The system (100) of claim 7 wherein the first environmental sensor (110-3) and the second environmental sensor (110-4) have an overlapping field of view and wherein the processor (120) is configured to
generate vehicle behavior data of a vehicle (140-1, 140-2) moving from a field of view of the first environmental sensor (110-3) to a field of view of the second environmental sensor (110-4).

11. The system (100) of any of the previous claims, wherein the processor (120) is further configured to classify vehicles (140-1, 140-2) regarding their vehicle type based on the sensor data.

12. The system (100) of any of the previous claims, wherein the observed vehicle behavior data is indicative of observed vehicle driving trajectories, the driving behavior training data (310) is indicative of observed driving trajectories of vehicles (140-1, 140-2) interacting with each other within the traffic area (150), and the simulated vehicle behavior data (340) is indicative of simulated vehicle driving trajectories.

13. An apparatus for determining a computer model of realistic driving behavior for training an autonomous driving system, the apparatus comprising:

a machine learning based driving behavior simulator (130) configured to adjust driving behavior model parameters (320) by reducing a deviation between the driving behavior training data (310) modified by at least one error model and simulated vehicle behavior data (340) generated by the machine learning based driving behavior simulator (130) and to train the autonomous driving system,

the driving behavior training data (310) being extracted from observed vehicle behavior data of vehicles (140-1, 140-2) interacting with each other within a traffic area (150),

the observed vehicle behavior data being extracted from sensor data;

the sensor data of observed vehicles (140-1, 140-2) within a traffic area (150) being generated using one or more environmental sensors (110).

the at least one error model being determined by comparing positional data with the sensor data of the one or more environmental sensors (110); and

the positional data of the observed vehicles (140-1, 140-2) being provided by one or more position sensors (160) installed on the observed vehicles (140-1, 140-2).

14. An apparatus for providing driving behavior training data (310) for a machine learning based driving behavior simulator (130) for training an autonomous driving system, the apparatus comprising:

one or more environmental sensors (110) configured to provide sensor data of observed vehicles (140-1, 140-2) within a traffic area (150);

one or more position sensors (160) installed on the observed vehicles (140-1, 140-2) providing positional data of the observed vehicles;

one or more processors (120) configured to determine at least one error model by comparing the positional data with the sensor data of the one or more environmental sensors (110);

extract observed vehicle behavior data from the sensor data and to extract the driving behavior training data (310) from observed vehicle behavior data of vehicles (140-1, 140-2) interacting with each other within the traffic area (150),

wherein the driving behavior training data (310) modified by the at least one error model can be used for adjusting driving behavior model parameters (320) of the machine learning based driving behavior simulator (130) by reducing a deviation between the driving behavior training data (310) and simulated vehicle behavior data (340) generated by the machine learning based driving behavior simulator (130) and training the autonomous driving system.

15. A method (200) for determining a computer model of realistic driving behavior for training an autonomous driving system, the method comprising:

providing (210) sensor data of observed vehicles (140-1, 140-2) within a traffic area (150) using one or more environmental sensors (110);

providing positional data of the observed vehicles (140-1, 140-2) using one or more position sensors (160) installed on the observed vehicles (140-1, 140-2)

extracting (220) observed vehicle behavior data from the sensor data;

extracting (230) driving behavior training data (310) from observed vehicle behavior data of vehicles (140-1, 140-2) interacting with each other within the traffic area (150);

determining at least one error model by comparing the positional data with the sensor data of the one or more environmental sensors (110);

adjusting (240) driving behavior model parameters (320) of a machine learning based driving behavior simulator (130) by reducing a deviation between the driving behavior training data (310) modified by the at least one error model and simulated vehicle behavior data (340) generated by the machine learning based driving behavior simulator (130); and

training an autonomous driving system using the driving behavior simulator (130).

**Patentansprüche**

1. System (100) zum Bestimmen eines Computermodells eines realistischen Fahrverhaltens zum Trainieren eines autonomen Fahrsystems, wobei das System Folgendes umfasst:

einen oder mehrere Umfeldsensoren (110), die konfiguriert sind, um Sensordaten beobachteter Fahrzeuge (140-1, 140-2) innerhalb eines Verkehrsbereichs (150) bereitzustellen;

einen oder mehrere Positionssensoren (160), die in den beobachteten Fahrzeugen (140-1, 140-2) verbaut sind und Positionsdaten der beobachteten Fahrzeuge (140-1, 140-2) bereitstellen;
einen Prozessor (120), der für Folgendes konfiguriert ist:

Bestimmen mindestens eines Fehlermodells durch Vergleichen der Positionsdaten mit den Sensordaten des einen oder der mehreren Umfeldsensoren (110);
Extrahieren von das Verhalten beobachteter Fahrzeuge betreffenden Daten aus den Sensordaten und Extrahieren von Fahrverhaltenstrainingsdaten (310) aus das Verhalten beobachteter Fahrzeuge betreffenden Daten von innerhalb des Verkehrsbereichs (150) miteinander interagierenden Fahrzeugen (140-1, 140-2); und

einen auf maschinellem Lernen basierenden Fahrverhaltenssimulator (130), der für Folgendes konfiguriert ist:
Anpassen von Fahrverhaltensmodellparametern (320) durch Verkleinern einer Abweichung zwischen den Fahrverhaltenstrainingsdaten (310), die durch das mindestens eine Fehlermodell modifiziert werden, und Fahrzeugverhaltenssimulationsdaten (340), die durch den auf maschinellem Lernen basierenden Fahrverhaltenssimulator (130) generiert werden, und Trainieren des autonomen Fahrsystems.

2. System (100) nach Anspruch 1, wobei die Umfeldsensoren (110) einen oder mehrere stationäre erste Umfeldsensoren, um erste Sensordaten bereitzustellen, und einen oder mehrere zweite Umfeldsensoren, die in den beobachteten Fahrzeugen (140-1, 140-2) verbaut sind, um zweite Sensordaten bereitzustellen, umfassen.

3. System (100) nach Anspruch 2, wobei der Prozessor (120) ferner konfiguriert ist, um die ersten Sensordaten aus seinem Bezugssystem einem Bezugssystem der zweiten Sensordaten durch Vergleichen der ersten und der zweiten Sensordaten mit den Positionsdaten zuzuordnen.

4. System (100) nach Anspruch 3, wobei der Prozessor (120) ferner für Folgendes konfiguriert ist:

Bestimmen eines ersten Fehlermodells durch Vergleichen der zugeordneten ersten Sensordaten mit den Positionsdaten;
Bestimmen eines zweiten Fehlermodells durch Vergleichen der zweiten Sensordaten mit den Positionsdaten;
Extrahieren erster das Verhalten beobachteter Fahrzeuge betreffender Daten aus den zugeordneten ersten Sensordaten;
Extrahieren erster Fahrverhaltenstrainingsdaten aus den ersten das Verhalten beobachteter Fahrzeuge betreffenden Daten von innerhalb des Verkehrsbereichs (150) miteinander interagierenden Fahrzeugen;
Extrahieren zweiter das Verhalten beobachteter Fahrzeuge betreffender Daten aus den zweiten Sensordaten;
Extrahieren zweiter Fahrverhaltenstrainingsdaten aus den zweiten das Verhalten beobachteter Fahrzeuge betreffenden Daten von innerhalb des Verkehrsbereichs (150) miteinander interagierenden Fahrzeugen;
Modifizieren der ersten Fahrverhaltenstrainingsdaten durch Anwenden des ersten Fehlermodells auf die ersten Fahrverhaltenstrainingsdaten;
Modifizieren der zweiten Fahrverhaltenstrainingsdaten durch Anwenden des zweiten Fehlermodells auf die zweiten Fahrverhaltenstrainingsdaten;
Generieren der durch das erste und das zweite Fehlermodell modifizierten Fahrverhaltenstrainingsdaten, indem die modifizierten ersten und die zweiten Fahrverhaltenstrainingsdaten (1010, 1020) einander zugeordnet werden.

5. System (100) nach Anspruch 1, wobei der auf maschinellem Lernen basierende Fahrverhaltenssimulator (130) für Folgendes konfiguriert ist:

Generieren einer Belohnungsfunktion (330) basierend auf den Fahrverhaltenstrainingsdaten (310), wobei eine Ausgabe der Belohnungsfunktion (330) eine Ähnlichkeit zwischen den Fahrverhaltenstrainingsdaten (310) und Fahrzeugverhaltenssimulationsdaten (340), die in die Belohnungsfunktion (330) eingegeben werden, angibt,
Bestimmen verbesserter Fahrzeugverhaltenssimulationsdaten (340), die die Ausgabe der Belohnungsfunktion (330) für die Fahrzeugverhaltenssimulationsdaten (340) vergrößern, und
Bestimmen der Fahrverhaltensmodellparameter (320) unter den verbesserten Fahrzeugverhaltenssimulationsdaten.

6. System (100) nach Anspruch 1, wobei der auf maschinellem Lernen basierende Fahrverhaltenssimulator (130) für Folgendes konfiguriert ist:

Bereitstellen eines Diskriminators (500) mit einer Fehlerrate für die Unterscheidung zwischen den Fahrverhaltenstrainingsdaten (310) und den Fahrzeugverhaltenssimulationsdaten (340) und

Anpassen der Fahrverhaltensmodellparameter (320), um zu bewirken, dass sich die Fehlerrate für die Unterscheidung zwischen den Fahrverhaltenstrainingsdaten (310) und den Fahrzeugverhaltenssimulationsdaten (340) erhöht.

7. System (100) nach Anspruch 1, wobei der auf maschinellem Lernen basierende Fahrverhaltenssimulator (130) für Folgendes konfiguriert ist:
Anpassen der Fahrverhaltensmodellparameter (320), um zu bewirken, dass eine Norm der Abweichung zwischen den Fahrzeugverhaltenssimulationsdaten (340) und den Fahrverhaltenstrainingsdaten (310) rekursiv verkleinert wird.

8. System (100) nach einem der vorherigen Ansprüche, wobei der Verkehrsbereich (150) einen ersten Verkehrsbereich (150-1) und einen zweiten Verkehrsbereich (150-2) umfasst, wobei der erste Verkehrsbereich (150-1) durch mindestens einen ersten Umfeldsensor (110-3) überwacht wird und der zweite Verkehrsbereich (150-2) durch mindestens einen zweiten Umfeldsensor (110-4) überwacht wird.

9. System (100) nach Anspruch 7, wobei der erste Umfeldsensor (110-3) und der zweite Umfeldsensor (110-4) entlang einer Strecke zum Tracken von die Strecke entlangfahrenden Fahrzeugen (140-1, 140-2) positioniert sind.

10. System (100) nach Anspruch 7, wobei der erste Umfeldsensor (110-3) und der zweite Umfeldsensor (110-4) ein überlappendes Sichtfeld aufweisen und wobei der Prozessor (120) für Folgendes konfiguriert ist:
Generieren von Fahrzeugverhaltensdaten eines sich aus einem Sichtfeld des ersten Umfeldsensors (110-3) in ein Sichtfeld des zweiten Umfeldsensors (110-4) bewegenden Fahrzeugs (140-1, 140-2).

11. System (100) nach einem der vorherigen Ansprüche, wobei der Prozessor (120) ferner konfiguriert ist, um Fahrzeuge (140-1, 140-2) hinsichtlich ihres Fahrzeugtyps basierend auf den Sensordaten zu klassifizieren.

12. System (100) nach einem der vorherigen Ansprüche, wobei die das Verhalten beobachteter Fahrzeuge betreffenden Daten beobachtete Fahrzeugfahrtrajektorien angeben, die Fahrverhaltenstrainingsdaten (310) beobachtete Fahrtrajektorien von innerhalb des Verkehrsbereichs (150) miteinander interagierenden Fahrzeugen (140-1, 140-2) angeben und die Fahrzeugverhaltenssimulationsdaten (340) simulierte Fahrzeugfahrtrajektorien angeben.

13. Vorrichtung zum Bestimmen eines Computermodells eines realistischen Fahrverhaltens zum Trainieren eines autonomen Fahrsystems, wobei die Vorrichtung Folgendes umfasst:

einen auf maschinellem Lernen basierenden Fahrverhaltenssimulator (130), der konfiguriert ist, um Fahrverhaltensmodellparameter (320) durch Verkleinern einer Abweichung zwischen den Fahrverhaltenstrainingsdaten (310), die durch mindestens ein Fehlermodell modifiziert werden, und Fahrzeugverhaltenssimulationsdaten (340), die durch den auf maschinellem Lernen basierenden Fahrverhaltenssimulator (130) generiert werden, anzupassen und das autonome Fahrsystem zu trainieren,
wobei die Fahrverhaltenstrainingsdaten (310) aus das Verhalten beobachteter Fahrzeuge betreffenden Daten von innerhalb eines Verkehrsbereichs (150) interagierenden Fahrzeugen (140-1, 140-2) extrahiert werden,
wobei die das Verhalten beobachteter Fahrzeuge betreffenden Daten aus Sensordaten extrahiert werden,
wobei die Sensordaten beobachteter Fahrzeuge (140-1, 140-2) innerhalb eines Verkehrsbereichs (150) unter Nutzung eines oder mehrerer Umfeldsensoren (110) generiert werden,
wobei das mindestens eine Fehlermodell durch Vergleichen von Positionsdaten mit den Sensordaten des einen oder der mehreren Umfeldsensoren (110) bestimmt wird; und
wobei die Positionsdaten der beobachteten Fahrzeuge (140-1, 140-2) durch einen oder mehrere Positionssensoren (160), die in den beobachteten Fahrzeugen (140-1, 140-2) verbaut sind, bereitgestellt werden.

14. Vorrichtung zum Bereitstellen von Fahrverhaltenstrainingsdaten (310) für einen auf maschinellem Lernen basierenden Fahrverhaltenssimulator (130) zum Trainieren eines autonomen Fahrsystems, wobei die Vorrichtung Folgendes umfasst:

einen oder mehrere Umfeldsensoren (110), die konfiguriert sind, um Sensordaten beobachteter Fahrzeuge (140-1, 140-2) innerhalb eines Verkehrsbereichs (150) bereitzustellen;
einen oder mehrere Positionssensoren (160), die in den beobachteten Fahrzeugen (140-1, 140-2) verbaut sind und Positionsdaten der beobachteten Fahrzeuge bereitstellen;
einen oder mehrere Prozessoren (120), die für Folgendes konfiguriert sind:

Bestimmen mindestens eines Fehlermodells durch Vergleichen der Positionsdaten mit den Sensordaten des einen oder der mehreren Umfeldsensoren (110);
Extrahieren von das Verhalten beobachteter Fahrzeuge betreffenden Daten aus den Sensordaten und

Extrahieren der Fahrverhaltenstrainingsdaten (310) aus das Verhalten beobachteter Fahrzeuge betreffenden Daten von innerhalb des Verkehrsbereichs (150) miteinander interagierenden Fahrzeugen (140-1, 140-2),

wobei die Fahrverhaltenstrainingsdaten (310), die durch das mindestens eine Fehlermodell modifiziert werden, zum Anpassen von Fahrverhaltensmodellparametern (320) des auf maschinellem Lernen basierenden Fahrverhaltenssimulators (130) durch Verkleinern einer Abweichung zwischen den Fahrverhaltenstrainingsdaten (310) und Fahrzeugverhaltenssimulationsdaten (340), die durch den auf maschinellem Lernen basierenden Fahrverhaltenssimulator (130) generiert werden, und zum Trainieren des autonomen Fahrsystems genutzt werden können.

15. Verfahren (200) zum Bestimmen eines Computermodells eines realistischen Fahrverhaltens zum Trainieren eines autonomen Fahrsystems, wobei das Verfahren Folgendes umfasst:

Bereitstellen (210) von Sensordaten beobachteter Fahrzeuge (140-1, 140-2) innerhalb eines Verkehrsbereichs (150) unter Nutzung eines oder mehrerer Umfeldsensoren (110);

Bereitstellen von Positionsdaten der beobachteten Fahrzeuge (140-1, 140-2) unter Nutzung eines oder mehrerer Positionssensoren (160), die in den beobachteten Fahrzeugen (140-1, 140-2) verbaut sind,

Extrahieren (220) von das Verhalten beobachteter Fahrzeuge betreffenden Daten aus den Sensordaten;

Extrahieren (230) von Fahrverhaltenstrainingsdaten (310) aus das Verhalten beobachteter Fahrzeuge betreffenden Daten von innerhalb des Verkehrsbereichs (150) miteinander interagierenden Fahrzeugen (140-1, 140-2) ;

Bestimmen mindestens eines Fehlermodells durch Vergleichen der Positionsdaten mit den Sensordaten des einen oder der mehreren Umfeldsensoren (110);

Anpassen (240) von Fahrverhaltensmodellparametern (320) eines auf maschinellem Lernen basierenden Fahrverhaltenssimulators (130) durch Verkleinern einer Abweichung zwischen den Fahrverhaltenstrainingsdaten (310), die durch das mindestens eine Fehlermodell modifiziert werden, und Fahrzeugverhaltenssimulationsdaten (340), die durch den auf maschinellem Lernen basierenden Fahrverhaltenssimulator (130) generiert werden; und
Trainieren eines autonomen Fahrsystems unter Nutzung des Fahrverhaltenssimulators (130).

## Revendications

1. Système (100) pour déterminer un modèle informatique d'un comportement de conduite réaliste pour former un système de conduite autonome, ce système comprenant :

un ou plusieurs capteurs environnementaux (110) configurés de façon à fournir des données de capteur de véhicules observés (140-1, 140-2) dans une zone de trafic (150) ;
un ou plusieurs capteurs de position (160) installés sur les véhicules observés (140-1, 140-2) fournissant des données de position des véhicules observés (140-1, 140-2) ;
un processeur (120) configuré de façon à :

déterminer au moins un modèle d'erreur en comparant les données de position avec les données de capteur du ou des capteurs environnementaux (110) ;
extraire des données de comportement de véhicules observés à partir des données de capteur et à extraire des données d'apprentissage de comportement de conduite (310) à partir de données de comportement de véhicules observés de véhicules (140-1, 140-2) interagissant l'un avec l'autre dans la zone de trafic (150) ; et
un simulateur de comportement de conduite basé sur apprentissage machine (130) configuré de façon à :
régler des paramètres de modèle de comportement de conduite (320) en réduisant un écart entre les données d'apprentissage de comportement de conduite (310) modifiées par l'au moins un modèle d'erreur et des données de comportement de véhicule simulé (340) générées par le simulateur de comportement de conduite basé sur apprentissage machine (130) et de façon à former le système de conduite autonome.

2. Système (100) selon la revendication 1, dans lequel les capteurs environnementaux (110) comprennent un ou plusieurs premiers capteurs environnementaux fixes pour fournir des données de premier capteur et un ou plusieurs deuxièmes capteurs environnementaux installés sur les véhicules observés (140-1, 140-2) afin de fournir des données de deuxième capteur.

3. Système (100) selon la revendication 2, dans lequel le processeur (120) est configuré en outre de façon à mapper les données de premiers capteurs de son système de référence à un système de référence des données de deuxièmes capteurs en comparant les données des premiers et des deuxièmes capteurs avec les données de position.

4.  Système de (100) selon la revendication 3, dans lequel le processeur (120) est configuré en outre de façon à :

    déterminer un premier modèle d'erreur en comparant les données des premiers capteurs mappées avec les données de position ;
    déterminer un deuxième modèle d'erreur en comparant les données des deuxièmes capteurs mappées avec les données de position ;
    extraire des premières données de comportement de véhicules observés à partir des données des premiers capteurs mappées ;
    extraire des premières données d'apprentissage de comportement de conduite à partir de premières données de comportement de véhicules observés de véhicules interagissant l'un avec l'autre dans la zone de trafic (150) ;
    extraire des deuxièmes données de comportement de véhicules observés à partir des données des deuxièmes capteurs ;
    extraire des deuxièmes données d'apprentissage de comportement de conduite à partir de deuxièmes données de comportement de véhicules observés de véhicules interagissant l'un avec l'autre dans la zone de trafic (150) ;
    modifier les premières données d'apprentissage de comportement de conduite en appliquant le premier modèle d'erreur aux premières données d'apprentissage de comportement de conduite ;
    modifier les deuxièmes données d'apprentissage de comportement de conduite en appliquant le deuxième modèle d'erreur aux deuxièmes données d'apprentissage de comportement de conduite ;
    générer les données de formation de comportement de conduite modifiées par le premier et le deuxième modèle d'erreur en mappant les premières données d'apprentissage de comportement de conduite et les deuxièmes données d'apprentissage de comportement de conduite modifiées (1010, 1020) l'une sur l'autre.

5.  Système (100) selon la revendication 1, dans lequel le simulateur de comportement de conduite basé sur apprentissage machine (130) est configuré de façon à :

    générer une fonction de récompense (330) basée sur les données d'apprentissage de comportement de conduite (310), une sortie de la fonction de récompense (330) indiquant une similarité entre les données d'apprentissage de comportement de conduite (310) et des données de comportement de véhicule simulé (340) fournies à la fonction de récompense (330), déterminer des données de comportement de véhicule simulé amélioré (340) augmentant la sortie de la fonction de récompense (330) pour les données de comportement de véhicule simulé (340), et de façon à
    déterminer les paramètres du modèle de comportement de conduite (320) à partir des données de comportement de véhicule simulé améliorées.

6.  Système (100) selon la revendication 1, dans lequel le simulateur de comportement de conduite basé sur apprentissage machine (130) est configuré de façon à :
    fournir un discriminateur (500) ayant un taux de défaillance pour distinguer entre les données d'apprentissage de comportement de conduite (310) et les données de comportement de véhicule simulé (340), et à
    régler les paramètres du modèle de comportement de conduite (320) pour faire en sorte que le taux de défaillance pour distinguer entre les données d'apprentissage de comportement de conduite (310) et les données de comportement de véhicule simulé (340) augmente.

7.  Système (100) selon la revendication 1, dans lequel le simulateur de comportement de conduite basé sur apprentissage machine (130) est configuré de façon à :
    régler les paramètres du modèle de comportement de conduite (320) pour faire en sorte qu'une norme de l'écart entre les données de comportement de véhicule simulé (340) et les données d'apprentissage de comportement de conduite (310) diminue de manière récursive.

8.  Système (100) selon l'une quelconque des revendications précédentes, dans lequel la zone de trafic (150) comprend une première zone de trafic (150-1) et une deuxième zone de trafic (150-2), la première zone de trafic (150-1) étant surveillée par au moins un premier capteur environnemental (110-3) et la deuxième zone de trafic (150-2) étant surveillée par au moins un deuxième capteur environnemental (110-4).

9.  Système (100) selon la revendication 7, dans lequel le premier capteur environnemental (110-3) et le deuxième capteur environnemental (110-4) sont positionnés le long d'un itinéraire pour suivre des véhicules (140-1, 140-2) conduisant le long de cet itinéraire.

10. Système (100) selon la revendication 7, dans lequel le premier capteur environnemental (110-3) et le deuxième capteur environnemental (110-4) ont un champ de vision se chevauchant et dans lequel le processeur est configuré de façon à :
génerer des données de comportement de véhicule d'un véhicule (140-1, 140-2) se déplaçant d'un champ de vision du premier capteur environnemental (110-3) à un champ de vision du deuxième capteur environnemental (110-4).

11. Système (100) selon l'une quelconque des revendications précédentes, dans lequel le processeur (120) est configuré en outre de façon à classer des véhicules (140-1, 140-2) en ce qui concerne leur type de véhicule en se basant sur les données de capteur.

12. Système (100) selon l'une quelconque des revendications précédentes, dans lequel les données de comportement de véhicules observés sont indicatives des trajectoires de conduite de véhicules observées, les données d'apprentissage de comportement de conduite (310) sont indicatives des trajectoires de conduite observées des véhicules (140-1, 140-2) interagissant l'un avec l'autre dans la zone de trafic (150), et les données de comportement de véhicule simulé (340) sont indicatives de trajectoires de conduite de véhicule simulées.

13. Appareil pour déterminer un modèle informatique d'un comportement de conduite réaliste pour former un système de conduite autonome, cet appareil comprenant :

un simulateur de comportement de conduite basé sur apprentissage machine (130) configuré de façon à régler des paramètres de modèle de comportement de conduite (320) en réduisant un écart entre les données d'apprentissage de comportement de conduite (310) modifiées par au moins un modèle d'erreur et des données de comportement de véhicule simulé (340) générées par le simulateur de comportement de conduite basé sur apprentissage machine (130) et de façon à former le système de conduite autonome,
les données d'apprentissage de comportement de conduite (310) étant extraites à partir de données de comportement de véhicules observés de véhicules (140-1, 140-2) interagissant l'un avec l'autre dans une zone de trafic (150),
les données de comportement des véhicules observés étant extraites à partir de données de capteur ;
les données de capteur de véhicules observés (150, 140-2) dans une zone de trafic (150) étant générées en utilisant un ou plusieurs capteurs environnementaux (110) ;
l'au moins un modèle d'erreur étant déterminé en comparant des données de position avec les données de capteur du ou des capteurs environnementaux (110) ; et les données de position des véhicules observés (140-1, 140-2) étant fournies par un ou plusieurs capteurs de position (160) installés sur les véhicules observés (140-1, 140-2).

14. Appareil pour fournir des données d'apprentissage de comportement de conduite (310) pour un simulateur de comportement de conduite basé sur apprentissage machine (130) pour former un système de conduite autonome, cet appareil comprenant :

un ou plusieurs capteurs environnementaux (110) configurés de façon à fournir des données de capteur de véhicules observés (140-1, 140-2) dans une zone de trafic (150) ;
un ou plusieurs capteurs de position (160) installés sur les véhicules observés (140-1, 140-2) fournissant des données de position des véhicules observés ;
un ou plusieurs processeurs configurés de façon à :

déterminer au moins un modèle d'erreur en comparant les données de position avec les données de capteur du ou des capteurs environnementaux (110) ;
extraire des données de comportement de véhicules observés à partir des données de capteur et à extraire les données d'apprentissage de comportement de conduite (310) à partir de données de comportement de véhicules observés de véhicules (140-1, 140-2) interagissant l'un avec l'autre dans la zone de trafic (150) ;
les données d'apprentissage de comportement de conduite (310) modifiées par l'au moins un modèle d'erreur pouvant être utilisées pour régler des paramètres de modèle de comportement de conduite (320) du simulateur de comportement de conduite basé sur apprentissage machine (130) en réduisant un écart entre les données d'apprentissage de comportement de conduite (310) et des données de comportement de véhicule simulé (340) générées par le simulateur de comportement de conduite basé sur apprentissage machine (130) et formant le système de conduite autonome.

15. Procédé (200) pour déterminer un modèle informatique d'un comportement de conduite réaliste pour former un système de conduite autonome, ce système comprenant :

la fourniture (210) de données de capteur de véhicules observés (140-1, 140-2) dans une zone de trafic (150) en utilisant un ou plusieurs capteurs environnementaux (110) ;

la fourniture de données de position des véhicules observés (140-1, 140-2) en utilisant un ou plusieurs capteurs de position (160) installés sur les véhicules observés (140-1, 140-2) ;

l'extraction (220) de données de comportement de véhicules observés à partir des données de capteur ;

l'extraction (230) de données d'apprentissage de comportement de conduite (310) à partir de données de comportement de véhicules observés de véhicules (140-1, 140-2) interagissant l'un avec l'autre dans la zone de trafic (150) ;

la détermination d'au moins un modèle d'erreur en comparant les données de position avec les données de capteur du ou des capteurs environnementaux (110) ;

le réglage (240) de paramètres de modèle de comportement de conduite (320) d'un simulateur de comportement de conduite basé sur apprentissage machine (130) en réduisant un écart entre les données d'apprentissage de comportement de conduite (310) modifiées par l'au moins un modèle d'erreur et des données de comportement de véhicule simulé (340) générées par le simulateur de comportement de conduite basé sur apprentissage machine (130) ; et

la formation d'un système de conduite autonome en utilisant le simulateur de comportement de conduite (130) .

# Fig. 1

Fig. 2

200

| Providing sensor data of observed vehicles within a traffic area using one or more environmental sensors. | 210 |

| Extracting observed vehicle behavior data from the sensor data. | 220 |

| Extracting driving behavior training data from observed vehicle behavior data of vehicles interacting with each other within the traffic area. | 230 |

| Adjusting driving behavior model parameters of a machine learning based driving behavior simulator by reducing a deviation between the driving behavior training data and simulated vehicle behavior data generated by the machine learning based driving behavior simulator. | 240 |

Fig. 3

Fig. 4

Fig. 5

Fig. 6

110-1

Camera(s)

110-2

Radar /
Lidar

610

Image
processing

620

Data
processing

Fusion and
tracking

630

Driving behavior
training data

310

Fig. 7

110-3

110-4

150-1

150-2

140-1

140-2

140-1

140-2

Fig. 8

110-3

110-4

140-2

150-1

150-2

140-1

# Fig. 9

# Fig. 10

**EP 3 722 907 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2019035275 A1
- US 20190072966 A1